# EUROPÄISCHE PATENTSCHRIFT

(11) **EP 0 641 075 B1**
(45) Veröffentlichungstag und Bekanntmachung des Hinweises auf die Patenterteilung: **07.01.1998**
(21) Anmeldenummer: 94113221.9
(22) Anmeldetag: 24.08.1994
(51) Int. Cl.: H03H 19/00

(54) **Switched-Capacitor-Netzwerk**
Switched-capacitor circuit
Circuit à capacités commutées

(30) Priorität: 27.08.1993 DE 4328973
(43) Veröffentlichungstag der Anmeldung: 01.03.1995
(73) Patentinhaber: SIEMENS AKTIENGESELLSCHAFT, 80333 München (DE)
(72) Erfinder: Koch, Rudolf, Dr.-Ing., D-82041 Oberhaching (DE); Alger-Meunier, Michael, Dipl.-Ing., D-85540 Haar (DE)

(56) Entgegenhaltungen:
- EP-A- 0 396 786
- EP-A- 0 396 787

## Beschreibung

Die Erfindung betrifft ein Switched-Capacitor-Netzwerk mit einem Kondensator, der durch eine Schalteinrichtung abwechselnd geladen und entladen wird und der zum Laden auf eine Spannungsquelle aufgeschaltet wird.

Aktive Netzwerke benötigen zu ihrer Realisierung üblicherweise als aktives Bauelement einen Operationsverstärker sowie als passive Elemente Kondensatoren und Widerstände. Die Frequenzabhängigkeit des Netzwerkes wird dabei durch die verwendeten Kondensatoren und Widerstände bestimmt. Bei Switched-Capacitor-Netzwerken dagegen werden Widerstände durch geschaltete Kondensatoren simmuliert, wobei ein linearer Zusammenhang zwischen der Schaltfrequenz und dem einem ohmschen Widerstand entsprechenden äquivalenten Leitwert besteht. Damit kann auf einfache Weise durch Variation der Schaltfrequenz die Frequenzabhängigkeit des Netzwerkes verändert werden.

Wie beispielsweise bei U. Tietze, Ch. Schenk, Halbleiter-Schaltungstechnik, 9. Auflage 1991, Seite 450ff, beschrieben ist, werden die Kondensatoren eines Switched-Capacitor-Netzwerkes derart geschaltet, daß sie jeweils in einer Schaltphase geladen und in der darauffolgenden Schaltphase wiederum entladen werden. Anstelle des Entladens kann dabei auch ein Umladen treten, was einem Entladen mit anschließendem Aufladen entgegengesetzter Polarität entspricht. Der Beginn des Auf- bzw. Umladevorgangs stellt für die ladende Spannungsquelle eine starke Belastung dar, da der Kondensator kurzzeitig einen Kurzschluß bildet und der Strom hauptsächlich nur durch den Innenwiderstand der Spannungsquelle und den Übergangswiderstand der Schalteinrichtung begrenzt wird. Die Folge davon ist ein zunächst auftretender Spannungseinbruch an der Spannungsquelle und nachfolgend ein im wesentlichen durch die Kapazität des Kondensators, den Innenwiderstand der Spannungsquelle sowie den Übergangswiderstand der Schalteinrichtung bestimmter Einschwingvorgang. Dies kann jedoch zu einer unzureichenden Aufladung des jeweiligen Kondensators innerhalb der entsprechenden Schaltphase und zu daraus resultierenden Störungen des gesamten Netzwerkes führen.

Aufgabe der Erfindung ist es daher, ein Switched-Capacitor-Netzwerk anzugeben, das diese Nachteile nicht aufweist.

Die Aufgabe wird dadurch gelöst, daß bei einem Switched-Capacitor-Netzwerk der eingangs genannten Art ein zweiter Kondensator vorgesehen wird, der mittels einer zweiten Schalteinrichtung synchron zum ersten Kondensator geladen und entladen wird und zum Laden zwischen die erste Spannungsquelle und eine zweite Spannungsquelle geschaltet wird, wobei das Produkt aus der Kapazität des ersten Kondensators und der Spannung der ersten Spannungsquelle gleich dem Produkt aus der Kapazität des zweiten Kondensators und der Spannungsdifferenz beider Spannungsquellen ist und das Produkt aus der Kapazität des ersten Kondensators und dem Übergangswiderstand der ersten Schalteinrichtung in seinem Zuleitungspfad gleich dem Produkt aus der Kapazität des zweiten Kondensators und der Summe des Innenwiderstandes der zweiten Spannungsquelle und des Übergangswiderstandes der zweiten Schalteinrichtung im Zuleitungspfad des zweiten Kondensators ist.

Der Spannungseinbruch beim Aufschalten des ersten Kondensators mittels der ersten Schalteinrichtung und der daran anschließende Einschwingvorgang werden erfindungsgemäß dadurch kompensiert, daß mit Hilfe der zweiten Spannungsquelle in Verbindung mit dem zweiten Kondensator und der zweiten Schalteinrichtung ein gegenpoliger, ansonsten jedoch identischer Spannungsverlauf erzeugt und dem Verlauf an der ersten Spannungsquelle überlagert wird.

Üblicherweise sind die auf den Zuleitungen auftretenden Widerstände (bzw. Impedanzen) vernachläßigbar gegenüber dem Innenwiderstand der Spannungsquellen und dem Übergangswiderstand der Schalteinrichtung. Sie sind daher im allgemeinen auch ohne Einfluß auf die Funktion des Netzwerkes. Sollte dies jedoch nicht der Fall sein, so ist folglich auch eine Anpassung der Widerstände (Impedanzen) der Zuleitungen und ggf. weiterer Widerstände (Impedanzen) zwischen der zweiten Spannungsquelle und dem zweiten Kondensator an entsprechende Widerstände (Impedanzen) zwischen der ersten Spannungsquelle und dem ersten Kondensator erforderlich. Darüber hinaus ist bei Verwendung von Wechselspannungsquellen anstelle von Gleichspannungsquellen darauf zu achten, daß deren Spannungen gleichphasig sind. Derartige Wechselspannungsquellen werden beispielsweise mit zwei durch eine Signalquelle angesteuerte Verstärker mit unterschiedlichen Verstärkungen realisiert.

Bei einer Weiterbildung der Erfindung werden beide Kondensatoren sowie die zugehörigen Schalteinheiten differentiell, also doppelt ausgeführt. Werden also zwei erste Kondensatoren gleicher Kapazität, die die erste Schalteinrichtung abwechselnd und zueinander gegenphasig aus der ersten Spannungsquelle mit gegenüber einem Bezugspotential (M) gleichen Polaritäten aufladen und anschließend über jeweils einen Eingangskreis eines Differenzverstärkers (OP1, OP2) entladen werden und zwei zweite Kondensatoren mit gleicher Kapazität, die mittels der zweiten Schalteinrichtung synchron zu den ersten Kondensatoren abwechselnd geladen und entladen werden und die zum Laden zwischen die erste Spannungsquelle und die zweite Spannungsquelle geschaltet werden, vorgesehen.

Um signalabhängige Störungen, die durch die Belastung des Signalpfades hervorgerufen werden, zu unterdrücken, werden außerdem zwei dritte Kondensatoren mit gleicher Kapazität, die eine dritte Schalteinrichtung aus einer Signalspannungsquelle synchron zu den ersten Kondensatoren mit gegenüber dem Bezugspotential (M) entgegengesetzten Polaritäten zueinander aufladen und anschließend über jeweils einen Eingangskreis des Differenzverstärkers (OP1, OP2) entladen werden und zwei vierte Kondensatoren mit gleicher Kapazität wie die ersten Kondensatoren, die die dritte Schalteinheit gegenphasig zu dem jeweils entsprechenden ersten Kondensator aus der Spannungsquelle mit gegenüber dem Bezugspotential (M) gleichen Polaritäten aufladen und anschließend über jeweils einen Eingangskreis des Differenzverstärkers (OP1, OP2) entladen werden, hinzugefügt.

Die Erfindung wird nachfolgend anhand der in den Figuren der Zeichnung dargestellten Ausführungsbeispiele näher erläutert. Es zeigen
- Figur 1: ein allgemeines Ausführungsbeispiel eines erfindungsgemäßen Netzwerkes,
- Figur 2: den Verlauf der Schaltphasen bei dem Netzwerk nach Figur 1 und
- Figur 3: eine Anwendung der Erfindung bei einem bekannten Sigma-Delta-Modulator.

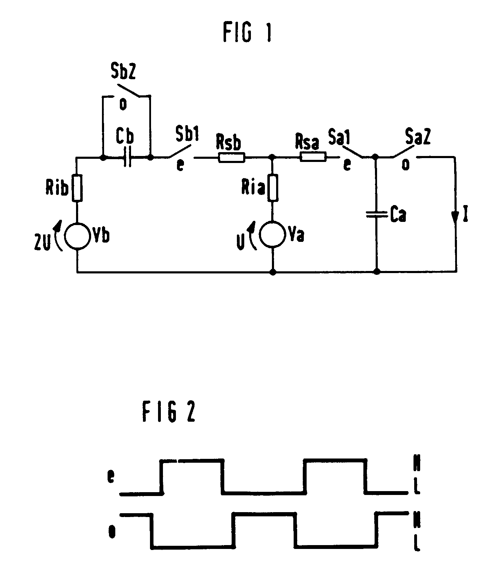

Bei dem Ausführungsbeispiel nach Figur 1 wird ein Kondensator Ca während einer ersten Schaltphase durch eine Spannungsquelle Va mit dem Innenwiderstand Rᵢₐ und der Spannung U geladen. Ein zwischen die Spannungsquelle Va und den Kondensator Ca geschalteter gesteuerter Schalter Sa1 ist dabei geschlossen, während ein zum Kondensator Ca parallel liegender gesteuerter Schalter Sa2 geöffnet ist. In einer nachfolgenden zweiten Schaltphase ist dann der Schalter Sa1 geöffnet und der Schalter Sa2 geschlossen, wodurch der Kondensator Ca entladen wird. Der mittlere Entladestrom I stellt dabei das Ausgangssignal dieses Netzwerkes dar. Im weiteren werden die Schalter Sa1 und Sa2 abwechselnd geöffnet bzw. geschlossen. Um nun die Spannungseinbrüche während der ersten Schaltphase und das nachfolgende Einschwingen zu kompensieren, sind eine weitere Spannungsquelle Vb mit einem Innenwiderstand R_{ib} und der doppelten Spannung 2U im Vergleich zur Spannungsquelle Va sowie ein weiterer Kondensator Cb und ein in Reihe dazuliegender gesteuerter Schalter Sb1 vorgesehen, die zwischen die beiden Spannungsquellen Va und Vb geschaltet sind. Schließlich ist ein Schalter Sb2 dem Kondensator Cb parallel geschaltet. Der Schalter Sa1 weist dabei einen Übergangswiderstand Rsa und der Schalter Sb1 einen Übergangswiderstand Rsb auf. Die Übergangswiderstände der Schalter Sa2 und Sb2 sind ausreichend zur vollständigen Entladung der entsprechenden Kondensatoren und wurden der Übersichtlichkeit halber nicht eingezeichnet. Zur Ansteuerung der Schalter Sa1, Sb1, Sa2 und Sb2 sind zwei zueinander gegenphasige, sich nicht überlappende Taktsignale e und o vorgesehen, wobei die Schalter Sa1 und Sb1 mit dem Taktsignal e und die Schalter Sa2 und Sb2 mit dem Taktsignal O angesteuert werden. Anstelle der Schalter Sa1 und Sa2 und Sb1, Sb2 können auch jeweils entsprechend angesteuerte Umschalter vorgesehen werden. Erfindungsgemäß sind aufgrund der Spannungsvorgaben die beiden Kondensatoren Ca und Cb mit gleicher Kapazität ausgeführt. Dementsprechend ist die Summe des Innenwiderstandes R_{ib} und des Übergangswiderstandes R_{sb} gleich dem Übergangswiderstand ^{R}sa.

Die Schaltphasen der Schalter Sa1, Sa2, Sb1 und Sb2 entsprechen dabei den Pegeln H der Taktsignale e und O. Die zeitliche Zuordnung beider Phasen ist in Figur 2 der Zeichnung dargestellt. Danach erfolgt fortlaufend die Generierung von Signalen entgegengesetzter Phase. Zunächst ist das Taktsignal e auf hohem Pegel H und das Taktsignal o auf niedrigem Pegel L. Nach einem Signalwechsel des Taktsignals e erfolgt nach kurzer Verzögerungszeit ein Signalwechsel des Taktsignals o von niedrigem Pegel L zu hohem Pegel H. Für eine bestimmte Zeit führt nun das Taktsignal o das Taktsignal H. Nach dem Signalübergang von Pegel H nach Pegel L des Taktsignals o erfolgt nach kurzer Verzögerungszeit ein Signalwechsel von Pegel L nach Pegel H bei dem Taktsignal e. Nun führt wiederum das Taktsignal e für eine gegebene Zeit den Pegel H bis wiederum ein Wechsel erfolgt undsoweiter.

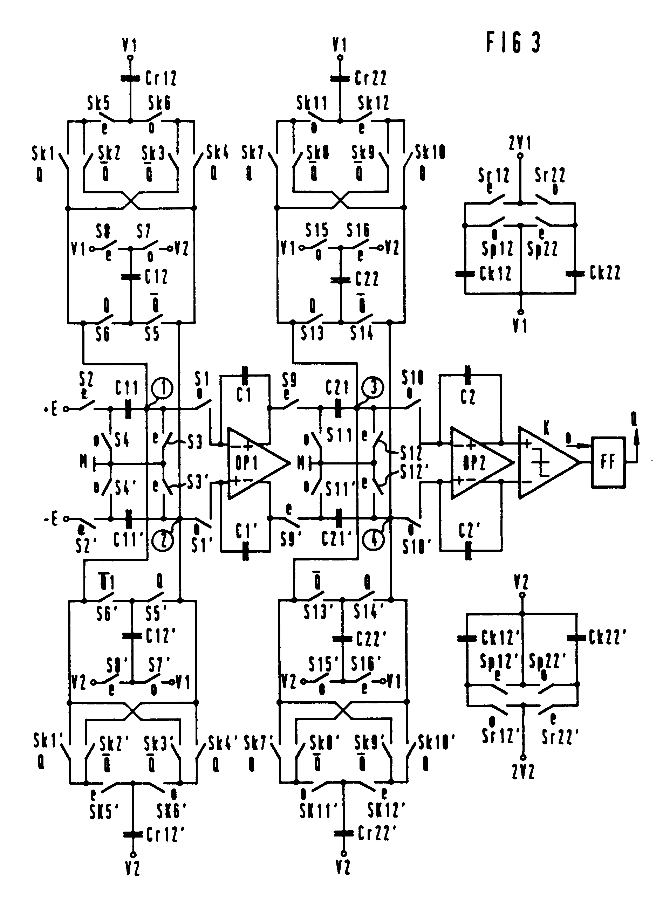

Die Erfindung wird nachfolgend bei einem aus der europäischen Offenlegungsschrift 0 396 786 bekannten Sigma-Delta-Modulator in Switched-Capacitor-Technik angewendet. Gemäß Figur 3 sind bei dem bekannten Sigma-Delta-Modulator zwei Operationsverstärker OP1 und OP2 vorgesehen. Beim Operationsverstarker OP1 ist zwischen nichtinvertiertem Ausgang und invertierendem Eingang eine Kapazität C1 und zwischen invertiertem Ausgang und nichtinvertierendem Eingang eine Kapazität C1' geschaltet. Der invertierende Eingang des Operationsverstärkers OP1 ist zudem über einen Schalter S1, über einen Kondensator C11 und über einen Schalter S2 mit einem Eingang +E und der nichtinvertierende Eingang des Operationsverstärkers OP1 über einen Schalter S1', über einen Kondensator C11' und über einen Schalter S2' mit einem Eingang -E verbunden. Darüber hinaus ist der dem Eingang +E zugewandte Anschluß des Kondensators C11 über einen Schalter S4 und dessen dem Eingang +E abgewandter Anschluß über einen Schalter S3 auf ein Bezugspotential M aufschaltbar. Entsprechend ist der dem Eingang - E zugewandte Anschluß des Kondensators C11' über einen Schalter S4' und dessen dem Eingang -E abgewandter Anschluß über einen Schalter S3' auf das Bezugspotential M aufschaltbar.

Der durch den Kondensator C11, den Schalter S3 und den Schalter S1 gebildete Knotenpunkt ist zum einen über einen Schalter S6 mit einem Kondensator C12 und zum anderen über einen Schalter S6' mit einem Kondensator C12' verbunden. Ebenso ist der durch den Kondensator C11', dem Schalter S3' und dem Schalter S1' gebildete Knotenpunkt über einen Schalter S5 mit dem Kondensator C12 und über einen Schalter S5' mit dem Kondensator C12' verbunden. Der jeweils andere Anschluß der Kondensatoren C12 und C12' ist zum einen über einen Schalter S8 bzw. S7' auf ein Potential V1 und über einen Schalter S7 bzw. S8' auf ein Potential V2 aufschaltbar.
Beim Operationsverstärker OP2 ist zwischen nichtinvertiertem Ausgang und invertierendem Eingang ein Kondensator C2 und zwischen invertiertem Ausgang und nichtinvertierendem Eingang ein Kondensator C2' geschaltet. Der nichtinvertierte Ausgang des Operationsverstärkers OP1 ist über einen Schalter S9, einen Kondensator C21 und einen Schalter S10 mit dem invertierenden Eingang des Operationsverstärkers OP2 verbunden. In gleicher Weise ist der invertierte Ausgang des Operationsverstärkers OP1 über einen Schalter S9', einen Kondensator C21' und einen Schalter S10' mit dem nichtinvertierenden Eingang des Operationsverstärkers OP2 verbunden. Darüber hinaus sind die dem Operationsverstärker OP1 zugewandten Anschlüsse der beiden Kondensatoren C21 und C21' über den Schalter S11 bzw. S11' und die dem Operationsverstärker OP2 abgewandten Anschlüsse über jeweils einen Schalter S12 bzw. S12' auf das Bezugspotential M aufschaltbar. An den durch den Kondensator C21, dem Schalter S12 und dem Schalter S10 gebildeten Knotenpunkt ist über einen Schalter S13 ein Kondensator C22 und über einen Schalter S13' ein Kondensator C22' angeschlossen.

Ebenso steht der durch den Kondensator C21', dem Schalter S12' und dem Schalter S10' gebildete Knotenpunkt über einen Schalter S14 mit dem Kondensator C22 und über einen Schalter S14' mit einem Kondensator C22' in Verbindung. Der andere Anschluß des Kondensators C22 bzw. C22' ist zum einen über einen Schalter S15 bzw. S16' auf das Potential V1 und über einen Schalter S14 bzw. S13' auf ein Potential V2 aufschaltbar.

Der nichtinvertierte Ausgang des Operationsverstärkers OP2 ist mit dem nichtinvertierenden Eingang eines Komparators K und der invertierte Ausgang des Operationsverstärkers OP2 mit dem invertierenden Eingang des Komparators K gekoppelt. Der Ausgang des Komparators K ist auf den Eingang eines als Speicherelement vorgesehenen Flip-Flops FF geführt, wobei am Ausgang des Flip-Flops FF ein Ausgangssignal Q anliegt.

Mit dem Taktsignal e werden die Schalter S2, S2', S3, S3', S8, S8', S9, S9', S12, S12', S16, S16' und der Komparator K gesteuert. Entsprechend werden die Schalter S1, S1', S4, S4', S7, S7', S11, S11', S10, S10', S15, S15' und das Flip-Flop FF mit dem Taktsignal o betrieben. Schließlich sind die Schaltzyklen der Schalter S6, S5', S13, S14' durch das Ausgangssignal Q und die Schaltzyklen der Schalter S5, S6', S13', S14 durch das invertierte Ausgangssignal Q festgelegt. Der Verlauf der Taktsignale e und o ist wiederum Figur 2 zu entnehmen.

Bei dem gezeigten Sigma-Delta-Modulator werden zum einen die Kondensatoren C11, C11', C21 und C21' aus Wechselspannungsquellen geladen, nämlich durch die symmetrischen Eingangssignale +E und -E bzw. durch die symmetrischen Ausgangssignale des Operationsverstärkers OP1. Dagegen werden die Kondensatoren C12, C12', C22 und C22' durch Referenzspannungsquellen aufgeladen, welche die konstanten Potentiale V1 und V2 erzeugen. Bei diesem Sigma-Delta-Modulator führen signalkorrelierte, in den jeweiligen Schaltphasen der Taktsignale e und o unterschiedliche kapazitive Belastungen der Referenzspannungsquellen zu unerwünschten Störsignalen im Signalzweig. So liegt beispielsweise der Kondensator C12 während der Schaltphase des Taktsignals e zum einen am Referenzpotential V1 und zum anderen an dem das virtuelle Bezugspotential bildenden Integratoreingang. Damit wird die das Referenzpotential V1 erzeugende Referenzspannungsquelle belastet und der Integrator mit dem Operationsverstärker OP1 und dem Kondensator C1 gestört. In der Schaltphase des Taktsignals o liegt dagegen der Kondensator C12' zwischen dem Referenzpotential V1 und dem Bezugspotential M und belastet ebenfalls die das Potential V1 erzeugende Referenzspannungsquelle ohne Wirkung jedoch auf das über den Kondensator C11 zugeführte Signal +E. Entsprechende Störungen werden in gleicher Weise auch durch die Kondensatoren C12', C22 und C22' hervorgerufen.

Es tritt auch eine Belastung der die Signale +E und -E erzeugenden Signalquellen auf, jedoch sind die dadurch hervorgerufenen Störungen aufgrund des symmetrischen Aufbaus des signalführenden Zweiges ohne bedeutende Auswirkungen, so daß hier eine erfindungsgemäße Kompensation der Spannungseinbrüche entfallen kann.

Zur Kompensation der durch die Einbrüche der Potentiale V1 und V2 hervorgerufenen Störungen in den signal führenden Zweigen sind den Kondensatoren C12, C12', C22 und C22' entsprechende, identisch aufgebaute Kondensatoren Ck12, Ck12', Ck22 und Ck22' vorgesehen. Den Kondensatoren Ck12 und Ck22' ist dabei jeweils ein durch das Taktsignal o gesteuerter Schalter Sp12 bzw. Sp22' sowie den Kondensatoren Ck12' und Ck22 jeweils ein durch das Taktsignal e gesteuerter Schalter Sp12' bzw. Sp22 parallel geschaltet, die für ein periodisches Entladen der zugehörigen Kondensatoren sorgen. Der Kondensator Ck12 ist dabei einerseits an das Potential V1 angeschlossen und andererseits unter Zwischenschaltung eines durch das Taktsignal e gesteuerten Schalters Sr12 mit einem Potential 2V1 gekoppelt. Dementsprechend ist der Kondensator Ck12' einerseits mit dem Potential V2 verbunden und andererseits über einen durch das Taktsignal o gesteuerten Schalter Sr12' mit einem Potential 2V2 koppelbar. Demzufolge sind die Kondensatoren Ck22 und Ck22' einerseits mit dem Potential V1 bzw. V2 verbunden und andererseits über jeweils einen durch das Taktsignal o bzw. e gesteuerten Schalter Sr22 bzw. Sr22' mit dem Potential 2V1 bzw. 2V2 aufschaltbar. Die Potentiale 2V1 und 2V2 weisen dabei jeweils den doppelten Wert der Potentiale V1 bzw. V2 auf.

Schließlich weisen die Spannungsquellen zur Erzeugung der Potentiale 2V1 und 2V2 einen zum Übergangswiderstand der Schalter Sr12, Sr12', Sr22 und Sr22' vernachlässigbaren Innenwiderstand auf, so daß zur Anpassung der Widerstände in den jeweiligen Zuleitungspfaden nur diese Übergangswiderstände angepaßt werden müssen. Da die identischen Kondensatoren C12, C12', C22 und C22' mittels jeweils drei identischer Schalter an das Potential V1 bzw. V2 einerseits und das Bezugspotential M andererseits gelegt werden, weisen sie Schalter Sr12, Sr12', Sr22 und Sr22' dementsprechend den dreifachen Übergangswiderstand dazu auf oder sie setzen sich aus drei dazu identischen, in Reihe geschalteten Schaltern zusammen. Die Verwendung möglichst vieler identischer Bauelemente (Schalter, Kondensatoren etc.) wird insbesondere bei einer Realisierung in integrierter Schaltungstechnik angestrebt, da identische Größen mit einer wesentlich höheren relativen Genauigkeit zueinander erzeugt werden können als andere Gräßenverhältnisse.

Um die Belastung des Signalpfades durch die Kondensatoren C12, C12', C22 bzw. C22' zu kompensieren, werden zudem zwischen den durch den Kondensator C11, den Schalter S1 und den Schalter S3 gebildeten Knotenpunkt, im folgenden Knotenpunkt 1 genannt, und das Potential V1 sowie zwischen den durch den Kondensator C11', den Schalter S1' und den Schalter S3' gebildeten Knotenpunkt, im folgenden Knotenpunkt 2 genannt, und das Potential V2 jeweils eine zusätzliche Kondensator-Schalter-Struktur vorgesehen. Ausgehend vom Knotenpunkt 1 führt jeweils ein Schalter Sk1 und ein Schalter Sk3 auf einen Schalter Sk5 bzw. Sk6, die wiederum einerseits miteinander sowie mit einem Anschluß eines Kondensators Cr12 verbunden sind. Der andere Anschluß des Kondensators Cr12 ist an das Potential V1 angeschlossen. Der Knotenpunkt 2 ist jeweils über einen Schalter Sk2 bzw. Sk4 mit dem Schalter Sk5 bzw. Sk6 gekoppelt. Außerdem ist der Knotenpunkt 1 zum einen über einen Schalter Sk1' mit einem Schalter Sk5' sowie durch einen Schalter Sk3' mit einem Schalter Sk6' und der Knotenpunkt 2 zum einen über einen Schalter Sk2' mit dem Schalter Sk5' und andererseits über einen Schalter Sk4' mit dem Schalter Sk6' koppelbar. Die Schalter Sk5' und Sk6' führen auf einen Anschluß eines Kondensators Cr12', an dessen anderen Anschluß das Potential V2 angelegt ist. Die Kondensatoren Cr12 und Cr12' entsprechen in ihrem Aufbau den Kondensatoren C12 bzw. C12'. Dabei werden die Schalter Sk5 und Sk5' durch das Taktsignal e und die Schalter Sk6 und Sk6' durch das Taktsignal o gesteuert. Zur Steuerung der Schalter Sk1, Sk1', Sk4 und Sk4' ist das Ausgangssignal Q sowie zur Ansteuerung der Schalter Sk2, Sk2', Sk3 und Sk3' ist das invertierte Ausgangssignal Q vorgesehen.

Dementsprechend sind auch zwischen den durch den Kondensator C21, den Schalter S10 und den Schalter S12 gebildeten Knotenpunkt 3 und das Potential V1 sowie zwischen den durch den Kondensator C21 den Schalter S10' und den Schalter S12' gebildeten Knotenpunkt 4 und das Potential V2 derartige Schalter-Kondensator-Strukturen geschaltet. Diese weisen jeweils einen Kondensator Cr22 bzw. Cr22' auf, dessen jeweils einer Anschluß an dem Potential V1 bzw. V2 liegt und dessen anderer Anschluß auf jeweils zwei Schalter Sk11 und Sk12 bzw. Sk11' und Sk12' geführt ist. Die Schalter Sk11 und Sk11' sind dabei über jeweils einen Schalter Sk7 bzw. Sk7' mit dem Knotenpunkt 3 und über jeweils einen Schalter Sk8 bzw. Sk8' mit dem Knotenpunkt 4 koppelbar. Schließlich sind die Schalter Sk12 und Sk12'über jeweils einen Schalter Sk9 bzw. Sk9' auf den Knotenpunkt 3 und durch jeweils einen Schalter Sk1O bzw. Sk1O' auf den Knotenpunkt 4 aufschaltbar. Die Schalter Sk7, Sk7', Sk1O und Sk1O' werden dabei durch das Ausgangssignal Q und die Schalter Sk8, Sk8', Sk9 und Sk9' durch das invertierte Ausgangssignal Q gesteuert. Schließlich werden die Schalter Sk11 und Sk11' mit dem Taktsignal o und die Schalter Sk12 und Sk12' mit dem Taktsignal e angesteuert. In Folge der Signalinvertierung durch den Integrierer mit dem Operationsverstärker OP1 und den Kondensatoren C1 und C1' werden die den Kondensatoren jeweils nächstgelegenen Schalter Sk11, Sk12 bzw. Sk11', Sk12' gegenüber den entsprechenden Schaltern Sk7, Sk8 bzw. Sk7', Sk8' durch das jeweils andere Taktsignal angesteuert. Die Kondensatoren C12 und C22 sind im übrigen identisch ausgeführt zu den Kondensatoren C12' bzw. C22'.

## Patentansprüche

1. Switched-Capacitor-Netzwerk mit einem ersten Kondensator (Ca), der mittels einer ersten Schalteinrichtung (Sa1, Sa2) abwechselnd geladen und entladen wird und der zum Laden auf eine erste Spannungsquelle (Va) aufgeschaltet wird,
**gekennzeichnet durch** einen zweiten Kondensator (Cb), der mittels einer zweiten Schalteinrichtung (Sb1, Sb2) synchron zum ersten Kondensator (Ca) geladen und entladen wird und der zum Laden zwischen die erste Spannungsquelle (Va) und eine zweite Spannungsquelle (Vb) geschaltet wird, wobei das Produkt aus der Kapazität des ersten Kondensators (Ca) und der Spannung der ersten Spannungsquelle (Va) gleich dem Produkt aus der Kapazität des zweiten Kondensators (Cb) und der Spannungsdifferenz beider Spannungsquellen (Va, Vb) ist und das Produkt aus der Kapazität des ersten Kondensators (Ca) und dem Übergangswiderstand der ersten Schalteinrichtung (Sa1) in seinem Zuleitungspfad gleich dem Produkt aus der Kapazität des zweiten Kondensators (Cb) und der Summe des Innenwiderstandes (R_{ib}) der zweiten Spannungsquelle (Vb) und des Übergangswiderstandes der zweiten Schalteinrichtung (Sb1) im Zuleitungspfad des zweiten Kondensators (Cb) ist.

2. Switched-Capacitor-Netzwerk, nach Anspruch 1,
**gekennzeichnet durch** zwei erste Kondensatoren (C12, C12'; C22, C22') gleicher Kapazität, die durch die erste Schalteinrichtung (S5, S5' bis S8, S8') abwechselnd und zueinander gegenphasig aus der ersten Spannungsquelle (V1, V2) mit gegenüber einem Bezugspotential (M) gleichen Polaritäten aufgeladen werden und anschließend über jeweils einen Eingangskreis eines Differenzverstärkers (OP1, OP2) entladen werden und durch zwei zweite Kondensatoren (Ck12, Ck12'; Ck22, Ck22') mit gleicher Kapazität, die mittels der zweiten Schalteinrichtung (Sr12, Sr12', Sr22, Sr22', Sp12, Sp12', Sp22, Sp22') synchron zu den ersten Kondensatoren (C12, C12', C22, C22') abwechselnd geladen und entladen werden und die zum Laden zwischen die erste Spannungsquelle (V1, V2) und die zweite Spannungsquelle (2V1, 2V2) geschaltet werden.

3. Switched-Capacitor-Netzwerk nach Anspruch 2,
**gekennzeichnet durch** zwei dritte Kondensatoren (C11, C11', C21, C21'), mit gleicher Kapazität, die durch eine dritte Schalteinrichtung (S1, S1' bis S4, S4') aus einer Signalspannungsquelle (+E, -E) synchron zu den ersten Kondensatoren (C12, C12', C22, C22') mit gegenüber dem Bezugspotential (M) entgegengesetzten Polaritäten zueinander aufgeladen werden und anschließend über jeweils einen Eingangskreis des Differenzverstärkers (OP1, OP2) entladen werden und durch zwei vierte Kondensatoren (Cr12, Cr12', Cr22, Cr22') mit gleicher Kapazität wie die ersten Kondensatoren (C12, C12', C22, C22'), die durch die dritte Schalteinheit (S1, S1' bis S4, S4') gegenphasig zu dem jeweils entsprechenden ersten Kondensator (C12, C12', C22, C22') aus der Signalspannungsquelle (+E, -E) mit gegenüber dem Bezugspotential (M) gleichen Polaritäten aufgeladen und anschließend über jeweils einen Eingangskreis des Differenzverstärkers (OP1, OP2) entladen werden.

## Claims

1. Switched-capacitor network having a first capacitor (Ca), which is alternately charged and discharged by means of a first switching device (Sa1, Sa2) and is connected to a first voltage source (Va) in order to be charged, characterized by a second capacitor (Cb), which is charged and discharged by means of a second switching device (Sb1, Sb2) sychronously with the first capacitor (Ca) and is connected between the first voltage source (Va) and a second voltage source (Vb) in order to be charged, the product of the capacitance of the first capacitor (Ca) and the voltage of the first voltage source (Va) being equal to the product of the capacitance of the second capacitor (Cb) and the voltage difference between the two voltage sources (Va, Vb), and the product of the capacitance of the first capacitor (Ca) and the contact resistance of the first switching device (Sa1) in its lead path being equal to the product of the capacitance of the second capacitor (Cb) and the sum of the internal resistance (R_{ib}) of the second voltage source (Vb) and the contact resistance of the second switching device (Sb1) in the lead path of the second capacitor (Cb).

2. Switched-capacitor network, according to Claim 1, characterized by two first capacitors (C12, C12'; C22, C22') having the same capacitance, which are charged, by means of the first switching device (S5, S5' to S8, S8'), alternately and in antiphase with one another from the first voltage source (V1, V2) with identical polarities with respect to a reference-earth potential (M) and are subsequently discharged via a respective input circuit of a differential amplifier (OP1, OP2), and by two second capacitors (Ck12, Ck12'; Ck22, Ck22') having the same capacitance, which are alternately charged and discharged by means of the second switching device (Sr12, Sr12', Sr22, Sr22', Sp12, Sp12', Sp22, Sp22') synchronously with the first capacitors (C12, C12', C22, C22') and are connected between the first voltage source (V1, V2) and the second voltage source (2V1, 2V2) in order to be charged.

3. Switched-capacitor network according to Claim 2, characterized by two third capacitors (C11, C11', C21, C21'), having the same capacitance, which are charged, by means of a third switching device (S1, S1' to S4, S4') from a signal voltage source (+E, -E) synchronously with the first capacitors (C12, C12', C22, C22') with opposite polarities to one another with respect to the reference-earth potential (M) and are subsequently discharged via a respective input circuit of the differential amplifier (OP1, OP2), and by two fourth capacitors (Cr12, Cr12', Cr22, Cr22') having the same capacitance as the first capacitors (C12, C12', C22, C22'), which fourth capacitors are charged, by means of the third switching unit (S1, S1' to S4, S4'), in antiphase with the respectively corresponding first capacitor (C12, C12', C22, C22') from the signal voltage source (+E, -E) with identical polarities with respect to the reference-earth potential (M) and are subsequently discharged via a respective input circuit of the differential amplifier (OP1, OP2).

## Revendications

1. Circuit à capacités commutées comprenant un premier condensateur (Ca) qui est chargé et déchargé alternativement au moyen d'un premier dispositif de commutation (Sa1, Sa2) et qui, pour être chargé, est connecté à une première source de tension (Va), caractérisé par un second condensateur (Cb) qui est chargé et déchargé de manière synchrone avec le premier condensateur (Ca) au moyen d'un second dispositif de commutation (Sb1, Sb2) et qui, pour être chargé, est commuté entre la première source de tension (Va) et une seconde source de tension (Vb), le produit de la capacité du premier condensateur (Ca) et de la tension de la première source de tension (Va) étant égal au produit de la capacité du second condensateur (Cb) et de la différence de tension des deux sources de tension (Va, Vb), et le produit de la capacité du premier condensateur (Ca) et de la résistance de contact du premier dispositif de commutation (Sa1) dans son trajet d'alimentation étant égal au produit de la capacité du second condensateur (Cb) et de la somme de la résistance interne (Rib) de la seconde source de tension (Vb) et de la résistance de contact du second dispositif de commutation (Sb1) dans le trajet d'alimentation du second condensateur (Cb).

2. Circuit à capacités commutées selon la revendication 1, caractérisé par deux premiers condensateurs (C12, C12'; C22, C22') de même capacité qui, grâce au premier dispositif de commutation (S5, S5' à S8, S8'), sont chargés alternativement et en opposition de phase l'un par rapport à l'autre à partir de la première source de tension (V1, V2), avec des polarités identiques par rapport à un potentiel de référence (M), et sont ensuite déchargés respectivement par le biais d'un circuit d'entrée d'un amplificateur différentiel (OP1, OP2), et par deux seconds condensateurs (Ck12, Ck12'; Ck22, Ck22') de même capacité qui sont chargés et déchargés alternativement de manière synchrone avec les premiers condensateurs (C12, C12', C22, C22') au moyen du second dispositif de commutation (Sr12, Sr12', Sr22, Sr22', Sp12, Sp12', Sp22, Sp22') et qui, pour être chargés, sont commutés entre la première source de tension (V1, V2) et la seconde source de tension (2V1, 2V2).

3. Circuit à capacités commutées selon la revendication 2, caractérisé par deux troisièmes condensateurs (C11, C11', C21, C21') de même capacité qui, grâce à un troisième dispositif de commutation (S1, Sl' à S4, S4'), sont chargés de manière synchrone avec les premiers condensateurs (C12, C12', C22, C22') à partir d'une source de tension de signalisation (+E, -E), avec des polarités opposées par rapport au potentiel de référence (M), et sont ensuite déchargés respectivement par le biais d'un circuit d'entrée de l'amplificateur différentiel (OP1, OP2), et par deux quatrièmes condensateurs (Cr12, Cr12', Cr22, Cr22') ayant la même capacité que les premiers condensateurs (C12, C12', C22, C22') qui, grâce au troisième dispositif de commutation (S1, S1' à S4, S4'), sont chargés en opposition de phase par rapport au premier condensateur correspondant respectif (C12, C12', C22, C22') à partir de la source de tension (+E, -E) générant les signaux, avec des polarités identiques par rapport au potentiel de référence (M), et sont ensuite déchargés respectivement par le biais d'un circuit d'entrée de l'amplificateur différentiel (OP1, OP2).
